# EUROPÄISCHE PATENTSCHRIFT

(11) **EP 2 992 744 B1**
(45) Veröffentlichungstag und Bekanntmachung des Hinweises auf die Patenterteilung: **05.06.2019**
(21) Anmeldenummer: 14717121.9
(22) Anmeldetag: 10.04.2014
(51) Int. Cl.: H05K 3/12, H05K 3/22, F26B 3/30, F27B 9/06, H01L 21/67, H05K 1/09, H01L 21/677

(54) **VORRICHTUNG ZUM TROCKNEN UND SINTERN METALLHALTIGER TINTE AUF EINEM SUBSTRAT**
DEVICE FOR DRYING AND SINTERING METAL-CONTAINING INK ON A SUBSTRATE
DISPOSITIF POUR SÉCHER ET FRITTER UNE ENCRE À TENEUR MÉTALLIQUE SUR UN SUBSTRAT

(30) Priorität: 03.05.2013 DE 102013104577
(43) Veröffentlichungstag der Anmeldung: 09.03.2016
(73) Patentinhaber: Heraeus Noblelight GmbH, 63450 Hanau (DE)
(72) Erfinder: ZISSING, Holger, 36103 Flieden (DE); WEBER, Jürgen, 63801 Kleinostheim (DE); LINOW, Sven, 64285 Darmstadt (DE); WEISS, Oliver, 64404 Bickenbach (DE)
(74) Vertreter: Heraeus IP
(86) Internationale Anmeldenummer: PCT/EP2014/057258
(87) Internationale Veröffentlichungsnummer: WO 2014/177354

(56) Entgegenhaltungen:
- EP-A1- 0 631 098
- EP-A2- 1 158 836
- DE-A1-102010 015 659
- DE-A1-102010 044 299
- GB-A- 849 403
- LESZEK ADAM DOBRZANSKI ET AL: "Final Manufacturing Process of Front Side Metallisation on Silicon Solar Cells Using Conventional and Unconventional Techniques", STROJNISKI VESTNIK - JOURNAL OF MECHANICAL ENGINEERING, Bd. 59, Nr. 3, 15. März 2013 (2013-03-15), Seiten 175-182, XP055120644, ISSN: 0039-2480, DOI: 10.5545/sv-jme.2012.625
- Martyn Cherrington ET AL: "Ultrafast near-infrared sintering of a slot-die coated nano-silver conducting ink", Journal of Materials Chemistry, vol. 21, no. 21, 1 January 2011 (2011-01-01), page 7562, XP055512578, GB ISSN: 0959-9428, DOI: 10.1039/c1jm10630a

## Beschreibung

Die vorliegende Erfindung betrifft eine Vorrichtung zum Trocknen und Sintern metallhaltiger Tinte auf einem Substrat, aufweisend mehrere optische Strahler zur Bestrahlung des Substrats und einen Reflektor zur Reflexion von Strahlung auf das Substrat, wobei Strahler und Substrat in einer Transportrichtung relativ zueinander bewegbar sind.

Vorrichtungen zum Trocknen und Sintern metallhaltiger Tinten im Sinne der Erfindung werden zum Aushärten von Druckschichten verwendet; sie werden beispielsweise bei der Herstellung von elektronischen Schaltelementen eingesetzt, insbesondere bei der Herstellung von RFIDs, organischer Photovoltaik, OLEDs oder Printed Batteries.

### Stand der Technik

Es ist bekannt, dass elektronische Schaltelemente einfach und kostengünstig durch Druckverfahren hergestellt werden können. Solche elektronischen Schaltelemente werden daher auch als gedruckte Elektronik, *"Printed Functionalities"* oder *"Printed Electronics"* bezeichnet.

Bei der Herstellung von gedruckter Elektronik wird die metallhaltige Tinte zunächst in einem ersten Verfahrensschritt mittels eines Druckverfahrens als dünne Schicht auf ein geeignetes Substrat, beispielsweise auf eine Plastikfolie, ein Papier oder Glas, aufgebracht. Die Dicke der Tintenschicht liegt in der Regel zwischen 0,3 µm und 3,0 µm. Für das Aufbringen der Tintenschicht können eine Vielzahl verschiedener Druckverfahren eingesetzt werden. Häufig finden der Siebdruck, das Rolle-zu-Rolle-Verfahren oder der Tintenstrahldruck (*ink-jet printing*) Anwendung. Beim Tintenstrahldruck wird die metallhaltige Tinte von einem Tintenstrahldrucker tropfenweise auf das Substrat übertragen. Es zählt zu den Digitaldruckverfahren, da bei diesem Verfahren jedes Abbild neu erstellt wird.

Tinten, die bei der Herstellung von gedruckter Elektronik eingesetzt werden, enthalten einen hohen Anteil kleiner Metallpartikel, deren Teilchengröße häufig im Nanometerbereich liegt. Die Metallpartikel sind in einem wässrigen oder organischen Dispersionsmittel dispergiert. Darüber hinaus können die Tinten organische Zusätze enthalten, etwa zur besseren Partikelvernetzung, Löslichkeit, Benetzbarkeit oder zur Verhinderung von Agglomeration, aber auch wässrige Zusätze zur besseren Verarbeitbarkeit der Tinten.

Um eine elektrisch leitfähige und dauerhafte Beschichtung des Substrats zu erhalten, ist es notwendig die Tintenbeschichtung in einem zweiten Verfahrensschritt zu trocknen und zu sintern. Der zunächst stattfindende Trocknungsvorgang trägt dazu bei, dass flüchtige Bestandteile der Tinte, beispielsweise organische Zusätze oder das Dispersionsmittel, entfernt werden. In der auf dem Substrat verbleibenden Metallpartikel-Beschichtung liegen die Metallpartikel aber zunächst als einzelne Partikel vor, die durch einen anschließenden Sintervorgang miteinander verbunden werden müssen, um eine leitfähige Beschichtung zu erhalten. Eine hohe elektrische Leitfähigkeit erreichen beispielsweise Tinten mit Nanopartikeln aus Silber, die einen Feststoffgehalt von etwa 50% aufweisen.

Bei der Herstellung gedruckter Elektronik werden eine Vielzahl von Trocknungs- und Sinterverfahren eingesetzt. Beispielsweise kann eine Trocknung der Tintenbeschichtung durch Einsatz erwärmter Gase erreicht werden. Als Gase sind beispielsweise Luft, Stickstoff oder Edelgase geeignet. Da allerdings zur Herstellung gedruckter Elektronik in der Regel Substrate aus Kunststoff mit einer begrenzten thermischen Stabilität eingesetzt werden, kann die Temperatur der erwärmten Gase nicht beliebig hoch gewählt werden. Zumeist wird durch den Einsatz erwärmter Gase daher nur eine Trocknung der Beschichtung erreicht. Der Einsatz von Gasen zur Trocknung von Beschichtungen erfordert darüber hinaus einen hohen Platzbedarf und führt zu langen Prozesszeiten.

Um dennoch einen schnellen Trocknungs- und Sinterprozess zu gewährleisten, werden deshalb Strahlungsquellen zur Bestrahlung des beschichteten Substrats mit optischer Strahlung eingesetzt. Bei diesen Vorrichtungen werden sowohl UV-Strahlungsquellen, beispielsweise Quecksilberdampfentladungslampen oder LEDs, als auch Strahlungsquellen verwendet, die NIR-Strahlung emittieren, beispielsweise gepulste Xenon- oder Krypton-Blitzlampen oder NIR-Laserdioden.

So lehrt beispielsweise die US 2010/0003021 A1 eine Vorrichtung zum Trocknen und Sintern metallhaltiger Tinte mit einer einzelnen Strahlungsquelle, die zur Emission von Strahlung mit Wellenlängen im sichtbaren, Infrarot- und/oder UV-Bereich geeignet ist, beispielsweise in Form einer Xenon-Blitzlampe. Darüber hinaus umfasst die Vorrichtung eine Regeleinheit zur Regelung der Bestrahlung in Abhängigkeit von optischen Eigenschaften der aushärtenden Beschichtung.

Allerdings weisen Xenon-Blitzlampen einige Nachteile auf; sie erzeugen regelmäßig Strahlung mit einer hohen Leistungsdichte und sind vergleichsweise teuer. Darüber hinaus wird beim Einsatz einer Xenon-Blitzlampe das Bestrahlungsfeld nicht konstant bestrahlt. Insbesondere bei einer schnellen Relativbewegung von Substrat und Blitzlampe kann das Bestrahlungsfeld inhomogen ausgeleuchtet sein. Dies kann Einfluss auf die gleichmäßige Verdampfung von flüchtigen Bestandteilen der metallhaltigen Tinte haben.

Weiterhin hat es sich gezeigt, dass der Einsatz einer einzigen Strahlungsquelle zum gleichzeitigen Trocknen und Sintern der metallhaltigen Tinte zu einem unvollständig verlaufenden Sinterprozess führen kann. Gleichzeitig ablaufende Trocken- und Sinterprozesse können dazu führen, dass eine oberflächliche Sinterung bereits einsetzt, während die flüchtigen Bestandteile aus tiefer gelegenen Schichten der Beschichtung noch nicht vollständig verdampft sind. Werden diese flüchtigen Bestandteile während des gemeinsamen Trocken- und Sinterprozesses weiter erwärmt, können mikroskopische Explosionen auftreten, die die bereits gesinterte Schicht beschädigen können. Derartige Explosionen beeinträchtigen regelmäßig die Leitfähigkeit der Beschichtung.

Um diesen Nachteil zu vermeiden, wird in der US 2013/0043221 A1, aus der eine Vorrichtung der eingangs genannten Gattung bekannt ist, vorgeschlagen, zur Verdampfung flüchtiger Bestandteile eine erste Blitzlampe mit niedriger Bestrahlungsleistung vorzusehen und dieser, in Transportrichtung des Substrats gesehen, eine separate zweite Blitzlampe mit höherer Strahlungsleistung zum Sintern der Beschichtung nachzuordnen.

### Technische Aufgabe

Eine separate Anordnung zweier Strahlungsquellen setzt einen großen Bauraum voraus, in dem die Strahlungsquellen angeordnet sind; sie beeinträchtigt einen kompakten Aufbau der Vorrichtung. Eine Vorrichtung mit mehreren Blitzlichtlampen ist darüber hinaus aufwendig zu fertigen und trägt zu hohen Herstellungskosten bei. Blitzlampen weisen darüber hinaus die oben genannten Nachteile auf; sie sind teuer und regelmäßig für eine hohe Bestrahlungsdichte ausgelegt.

Der Erfindung liegt daher die Aufgabe zugrunde, eine effiziente Vorrichtung zum Trocknen und Sintern metallhaltiger Tinte anzugeben, die eine homogene Bestrahlung des Substrats ermöglicht, eine kompakte Bauform aufweist und darüber einfach und kostengünstig zu fertigen ist.

### Allgemeine Beschreibung der Erfindung

Diese Aufgabe wird ausgehend von einer Vorrichtung zum Trocknen und Sintern metallhaltiger Tinte der eingangs genannten Gattung erfindungsgemäß entsprechend den Ansprüchen dadurch gelöst, dass die optischen Strahler Infrarotstrahler mit einem zylinderförmigen Strahlerrohr und einer Strahlerrohr-Längsachse sind, die Strahlung mit einem Strahlungsanteil an IR-B-Strahlung von mindestens 30% und IR-C-Strahlung von mindestens 5% der Gesamtstrahlerleistung emittieren und die in einem Strahlermodul so angeordnet sind, dass ihre Strahlerrohr-Längsachsen parallel zueinander und quer zur Transportrichtung verlaufen und dabei auf der Oberfläche des Substrats ein Bestrahlungsfeld derart bestrahlen, dass dieses in eine Trocknungszone sowie eine der Trocknungszone in Transportrichtung gesehen nachgelagerte Sinterzone geteilt wird, wobei die Trocknungszone entlang einer in Transportrichtung verlaufenden Mittenachse eine um mindestens 15% geringere mittlere Bestrahlungsdichte als die Sinterzone ausgesetzt ist.

Ausgehend von einer gattungsgemäßen Vorrichtung zum Trocknen und Sintern metallhaltiger Tinte werden erfindungsgemäß zwei Modifikationen vorgeschlagen, von denen eine die Art des optischen Strahlers und die andere die Anordnung der optischen Strahler innerhalb eines dem Bestrahlungsfeld zugeordneten Strahlermoduls betrifft.

Es ist gängige Meinung, dass gute Verfahrensergebnisse bei der Trocknung und Sinterung metallhaltiger Tinten erzielt werden, wenn hierfür optische Strahler eingesetzt werden, die ein schmalbandiges oder diskretes Emissionsspektrum im sichtbaren oder IR-A-Bereich erzeugen (siehe hierzu: Z. Radivojevic et al.: Optimised curing of silver ink jet based printed traces, Proceedings of 12th International Workshop on Thermal Investigations of ICs -Therminic 2006, Nice: France (2006); R. Cauchois et al.: Impact of variable frequency microwave and rapid thermal sintering on microstructure of inkjet-printed silver nanoparticles, J. Mat. Sci 47, (2012), p. 20; J. West et al.: Photonic Sintering of Silver Nanoparticles: Comparison of Experiment and Theory, in Volodymyr Shatokha [Ed.]: Sintering-Methods and Products. InTech: 2012; A. Khan et al.: Laser sintering of direct write silver nano-ink conductors for microelectronic applications. Proc. SPIE 6879 (2008)).

Dokument DE102010015659A1 offenbart die Verwendung von Infrarotstrahlung zum Trocknen und Sintern von Tinten mit metallenen Nanopartikeln auf einem Substrat.

Im Gegensatz hierzu weist die erfindungsgemäße Vorrichtung mehrere Infrarotstrahler auf, deren Emissionsspektrum wesentliche Strahlungsanteile im IR-Bund IR-C-Bereich umfasst.

Metallhaltige Tinten sind eine Dispersion fester Metallpartikel in einem Dispersionsmittel. Die Metallpartikel selbst weisen eine hohe Reflektivität für auftreffende IR-B- und IR-C-Strahlung auf. Die von den Infrarotstrahlern emittierte IR-B- und IR-C-Strahlung und die von den Metallpartikeln diffus reflektierte Strahlung verteilt sich innerhalb der zu trocknenden Schicht und steht daher hauptsächlich für eine Bestrahlung der weiteren Bestandteile der metallhaltigen Tinte zur Verfügung.

Diese Bestandteile umfassen häufig organische Verbindungen, die gute Absorptionseigenschaften für Strahlung mit Wellenlängen in diesem Bereich aufweisen. Die IR-B- und IR-C-Strahlung wird regelmäßig vom Dispersionsmittel und flüchtigen Substanzen absorbiert, so dass diese Bestandteile verdampfen können. Sie trägt daher zu einer guten Trocknung der Tinte bei, bevor die Metallpartikel in einem Sintervorgang miteinander verbunden werden. Der Einsatz von IR-B- und IR-C-Strahlung führt folglich auch zu einem verringerten Auftreten von Mikroexplosionen bei einem nachfolgenden Sintervorgang.

Die Gesamtstrahlerleistung ist die integrale Bestrahlungsleistung in Watt bezogen auf die Emissionsfläche der Strahlerrohranordnung. Gute Ergebnisse werden erzielt, wenn die Infrarotstrahler Strahlung mit einem Strahlungsanteil an IR-B-Strahlung von mindestens 30% der Gesamtstrahlerleistung und Strahlung mit einem Strahlungsanteil an IR-C-Strahlung von mindestens 5% der Gesamtstrahlerleistung emittieren.

In diesem Zusammenhang hat sich bewährt, wenn die Infrarotstrahler weiterhin Strahlungsanteile im sichtbaren und IR-A-Bereich emittieren. Strahlung mit Wellenlängen in diesem Bereich weist im Vergleich zu IR-B- und IR-C-Strahlung eine höhere Strahlungsenergie auf und ist insbesondere zur Sinterung der Metallpartikel geeignet. IR-A-Strahlung weist Wellenlängen im Bereich von 0,78 µm bis 1,4 µm auf, die Wellenlängen von IR-B-Strahlung liegen im Bereich von 1,4 µm bis 3,0 µm und die von IR-C-Strahlung im Bereich von 3 µm bis 1000 µm.

Erfindungsgemäß ist darüber hinaus vorgesehen, dass die Infrarotstrahler in einem gemeinsamen Strahlermodul angeordnet sind. Im Gegensatz zu mehreren separaten Strahlern benötigt ein solches Strahlermodul nur ein gemeinsames Gehäuse für die Infrarotstrahler und trägt so zu einer kompakten Bauform der erfindungsgemäßen Vorrichtung bei.

Darüber hinaus wird durch den Einsatz von Infrarotstrahlern mit einem zylinderförmigen Strahlerrohr eine kompakte Anordnung der Infrarotstrahler in dem gemeinsamen Strahlermodul ermöglicht. Dazu trägt bei, dass erfindungsgemäß die Infrarotstrahler innerhalb des Strahlermoduls mit ihren Strahlerrohr-Längsachsen parallel zueinander angeordnet sind. Gleichzeitig wird durch die parallele Anordnung der Strahlerrohre ein Flächenstrahler erhalten, der für eine flächenhafte Bestrahlung des Substrats mit hohen Bestrahlungsdichten geeignet ist. Hierzu trägt auch die Anordnung der Infrarotstrahler bei, deren Strahlerrohr-Längsachsen quer zur Transportrichtung verlaufen. In diesem Zusammenhang hat es sich bewährt, wenn die Strahlerrohr-Längsachsen in einem Winkelbereich von 45° bis 90° versetzt zur Transportrichtung verlaufen. Im einfachsten Fall ist das Strahlermodul derart angeordnet, dass die Strahlerrohr-Längsachsen der Infrarotstrahler senkrecht zur Transportrichtung verlaufen.

Das Strahlermodul ist dabei so gestaltet, dass es ein Bestrahlungsfeld mit zwei unterschiedlichen Zonen erzeugt, nämlich mit einer Trocknungszone und einer Sinterzone. Unter dem Begriff Bestrahlungsfeld wird die gleich große Orthogonalprojektion des Strahlermoduls auf eine durch das Substrat festgelegte Ebene verstanden.

Trocknungszone und Sinterzone unterscheiden sich in der Bestrahlungsdichte. Die Bestrahlungsdichten beider Zonen sind an die bei der Trocknung und Sinterung metallhaltiger Tinte ablaufenden Prozesse angepasst. Beide Zonen können darüber hinaus unterschiedliche Maximal-Temperaturen und Temperaturprofile aufweisen.

Trocknungszone und Sinterzone grenzen unmittelbar aneinander oder weisen einen Abstand zueinander auf. Zwischen der Trocknungs- und der Sinterzone kann eine Übergangsszone angeordnet sein, deren Bestrahlungsdichte im Bereich zwischen der Bestrahlungsdichte der Trocknungszone und der der Sinterzone liegt.

Dadurch, dass das Strahlermodul und das Substrat relativ zueinander in Transportrichtung bewegbar sind, durchläuft das Substrat sowohl die Trocknungszone als auch die Sinterzone. Das Strahlermodul so ausgerichtet, dass das Substrat zunächst die Trocknungszone und anschließend die Sinterzone durchläuft.

Gemäß der Erfindung weist die Trocknungszone entlang einer in Transportrichtung verlaufenden Mittenachse eine geringere mittlere Bestrahlungsdichte als die Sinterzone auf. Die geringere Bestrahlungsdichte der Trocknungszone im Vergleich zur Sinterzone geht mit einem geringeren Energieeintrag in die Trocknungszone einher, so dass während der Trocknung kaum Sintervorgänge stattfinden können. Die mittlere Bestrahlungsdichte der Sinterzone ist für das Sintern der Metallpartikel ausgelegt. Dadurch, dass die Beschichtung bereits die Trockenzone durchlaufen hat, wird in der Sinterzone ein effizienter Sintervorgang ermöglicht.

Die Bestrahlungsdichten von Trocknungszone und Sinterzone können beispielsweise durch eine geeignete Wahl des Abstandes zwischen benachbarten Strahlern, durch den Einsatz unterschiedlicher Strahlertypen, aber auch durch den Betrieb von Strahlern mit unterschiedlichen Betriebsparametern (beispielsweise Betriebsstrom, Betriebsspannung) erreicht werden.

Da die Trocknungszone und Sinterzone von einem gemeinsamen Strahlermodul erzeugt werden, weisen beide Zonen einen vergleichsweisen geringen Abstand zueinander auf. Hierdurch werden Abkühlprozesse verringert, die während des Transportes des Substrats von der Trocknungszone zur Sinterzone stattfinden können. Das Strahlermodul trägt somit zu einer hohen Energieeffizienz der erfindungsgemäßen Vorrichtung bei.

In der Ausgestaltung der erfindungsgemäßen Vorrichtung ist vorgesehen, dass die mehreren Infrarotstrahler einen Infrarotstrahler einer ersten Art mit einem Emissionsmaximum im Wellenlängenbereich zwischen 1.600 nm und 3.000 nm und einen Infrarotstrahler einer zweiten Art mit einem Emissionsmaximum im Wellenlängenbereich zwischen 900 nm und 1.600 nm umfassen. Infrarotstrahler mit unterschiedlichen Emissionsmaxima bewirken regelmäßig einen unterschiedlichen Energieeintrag in das Substrat. Der Einsatz unterschiedlicher Infrarotstrahler kann daher zur Ausbildung eines Bestrahlungsfeldes mit unterschiedlichen Zonen, wie Trocknungszone und Sinterzone, beitragen. Infrarotstrahler der ersten Art emittieren Strahlungsanteile, die insbesondere von flüchtigen Bestandteilen der metallhaltigen Tinte absorbiert wird. Sie sind daher insbesondere zur Bestrahlung der Trocknungszone geeignet. Infrarotstrahler der zweiten Art zeigen ein Emissionsmaximum zwischen 900 nm und 1.600 nm und führen daher regelmäßig zu einem höheren Energieeintrag in das Substrat. Die von Ihnen emittierte Strahlung wird auch von Metallpartikeln absorbiert. Sie sind daher geeignet, Sinterprozesse zu begünstigen. Vorzugsweise sind die Infrarotstrahler der zweiten Art zur Bestrahlung der Sinterzone vorgesehen.

In einer vorteilhaften Ausgestaltung der erfindungsgemäßen Vorrichtung ist vorgesehen, dass mehrere Infrarotstrahler der ersten Art und mehrere Infrarotstrahler der zweiten Art vorgesehen sind, und dass benachbarte Infrarotstrahler der ersten Art einen größeren Abstand zueinander aufweisen als benachbarte Infrarotstrahler der zweiten Art.

Der Abstand benachbarter Infrarotstrahler hat Einfluss auf die Bestrahlungsdichte des Bestrahlungsfeldes. Ein großer Abstand führt zu einer geringeren Bestrahlungsdichte, wohingegen ein geringerer Abstand mit einer höheren Bestrahlungsdichte einhergeht. Vorzugsweise sind die Infrarotstrahler der ersten Art der Trocknungszone des Bestrahlungsfeldes und die Infrarotstrahler der zweiten Art der Sinterzone des Bestrahlungsfeldes zugeordnet. Dadurch, dass die Infrarotstrahler der ersten Art einen größeren Abstand zueinander aufweisen als benachbarte Infrarotstrahler der zweiten Art, erzeugen diese eine geringere Bestrahlungsdichte. Diese ist gemäß der Erfindung insbesondere in der Trocknungszone vorteilhaft.

Es hat sich als vorteilhaft erweisen, wenn die Infrarotstrahler die Strahlung kontinuierlich emittieren.

Dadurch, dass in Vorrichtungen zum Trocknen und Sintern von Tinten das Substrat und die Strahlungsquelle relativ zueinander bewegbar sind, treten insbesondere bei diskontinuierlich betriebenen Strahlern, beispielsweise Blitzlampen, Schwankungen in der Bestrahlungsdichte auf. Infrarotstrahler, die kontinuierlich Strahlung emittieren, sind daher besonders zur gleichmäßigen Bestrahlung des Substrats geeignet. Ein Strahlermodul mit derartigen Infrarotstrahlern erzeugt ein zeitlich konstantes Bestrahlungsfeld.

Bei einer bevorzugten Ausführungsform der erfindungsgemäßen Vorrichtung weisen die Infrarotstrahler ein breitbandiges Emissionsspektrum auf, das Strahlungsanteile von zusammen mindestens 10% der Gesamtstrahlerleistung im sichtbaren Bereich und im IR-A-Bereich aufweist.

Strahler mit einem breitbandigen Emissionsspektrum können sowohl zur Trocknung als auch zur Sinterung der metallhaltigen Tinte eingesetzt werden. Insbesondere IR-A-Strahlung und Strahlung mit Wellenlängen im sichtbaren Bereich weisen im Vergleich zur IR-B- und IR-C-Strahlung eine höhere Strahlungsenergie auf und sind insbesondere zur Sinterung der Metallpartikel geeignet. Die Sintereffizienz hängt hierbei allerdings von der Bestrahlungsdichte ab. Bei Einsatz von Strahlern mit einem IR-A Anteil kleiner 30 % kann die Bestrahlungsdichte in der Trocknungszone und der Sinterzone beispielsweise durch eine geeignete Anpassung des Strahlerabstands benachbarter Strahler eingestellt werden.

In einer weiteren bevorzugten Modifikation der erfindungsgemäßen Vorrichtung ist vorgesehen, dass das Bestrahlungsfeld einen Gesamtflächeninhalt im Bereich von 800 cm² bis 6.000 cm², besonders bevorzugt im Bereich 1.500 bis 2.000 cm² aufweist, und dass der Flächeninhalt der Trocknungszone und der Sinterzone jeweils mindestens 30% des Gesamtflächeninhalts ausmacht, vorzugsweise der Flächeninhalt der Trocknungszone im Bereich zwischen 35% und 65% des Gesamtflächeninhalts liegt.

Der Flächeninhalt des Bestrahlungsfeldes beeinflusst die Trocknungs- und Sinterdauer pro Substratfläche. Ein Bestrahlungsfeld mit einem Flächeninhalt von weniger als 800 cm² führt pro Zeiteinheit nur zur Trocknung einer vergleichsweise geringen Substratfläche und führt somit zu hohen Trocknungskosten. Eine Vorrichtung mit einem Bestrahlungsfeld mit einem Gesamtflächeninhalt von mehr als 6.000 cm² und einer gleichzeitig guten Bestrahlungsdichteverteilung ist nur aufwendig zu fertigen.

Darüber hinaus ist es grundsätzlich wünschenswert, wenn die Flächen der Trocknungszone und der Sinterzone einen möglichst großen Anteil des Gesamtflächeninhalts aufweisen. Für einen effizienten Trocknungsvorgang hat sich daher als günstig erwiesen, wenn die Trocknungs- und die Sinterzone mindestens 30% des Gesamtflächeninhalts ausmachen. Da Substrat und Strahlermodul relativ zueinander beweglich sind, hängt die effektive Bestrahlungsdauer des Substrats vom Flächeninhalt der Trocknungs- beziehungsweise Sinterzone ab. Eine Zone mit einem großen Flächeninhalt führt zu einer zeitlich längeren Bestrahlung des Substrats. Um einen effizienten Trocknungs- und Sintervorgang zu gewährleisten, kann die Bestrahlungsdauer angepasst werden. Dies kann durch eine geeignete Wahl der Flächeninhalte der Trocknungs- und Sinterzone erfolgen. Bei einer Trocknungs-/Sinterzone mit einem Flächeninhalt im Bereich zwischen 35% und 65% des Gesamtflächeninhalts kann das Verhältnis der Bestrahlungsdauer von Trocknungs- und Sinterzone im Bereich zwischen etwa 1:2 und 2:1 angepasst werden.

Es hat sich als günstig erwiesen, wenn die Trocknungszone und die Sinterzone den gleichen Flächeninhalt aufweisen.

Haben Trocknungs- und Sinterzone den gleichen Flächeninhalt, wird eine effektive Bestrahlung des Substrats in beiden Zonen über einen vergleichbaren Zeitraum gewährleistet.

Vorzugsweise weist die Trocknungszone entlang der Mittenachse eine mittlere Bestrahlungsdichte von weniger als 50 kW/m² auf.

Bei einer mittleren Bestrahlungsdichte von mehr als 50 kW/m² kann es bereits in der Trocknungszone zum Einsetzen von Sinterprozessen kommen, die das Sinterergebnis beeinträchtigen können.

Es hat sich bewährt, wenn die Sinterzone entlang der Mittenachse eine Bestrahlungsdichte von mehr als 50 kW/m² aufweist.

Eine Bestrahlungsdichte von mehr als 50 kW/m² ist zum Sintern der Metallpartikel geeignet.

In einer bevorzugten Ausgestaltung der erfindungsgemäßen Vorrichtung ist das Strahlermodul für eine Bestrahlung des Bestrahlungsfelds mit einer mittleren Bestrahlungsdichte im Bereich von 30 kW/m² bis 250 kW/m² ausgelegt.

Die mittlere Bestrahlungsdichte bezogen auf das Bestrahlungsfeld hat Einfluss auf die Energieeffizienz der Vorrichtung. Grundsätzlich ist bezogen auf das gesamte Bestrahlungsfeld eine möglichst niedrige Bestrahlungsdichte wünschenswert. Allerdings ist eine mittlere Bestrahlungsdichte von weniger als 30 kW/m² zum Sintern der metallhaltigen Tinte nur bedingt geeignet. Eine Bestrahlungsdichte von mehr als 250 kW/m² beeinträchtigt die Energieeffizienz der Vorrichtung.

Es hat sich als günstig erwiesen, wenn das Strahlermodul ein Kühlelement, vorzugsweise eine Wasserkühlung, aufweist, das einer den Infrarotstrahlern abgewandten Seite des Reflektors angeordnet ist.

Eine übermäßige Erwärmung des Reflektor und der Infrarotstrahler trägt zu einer verringerten Lebensdauer der Vorrichtung bei. Ein Kühlelement, insbesondere eine Wasserkühlung, ermöglicht eine effektive Kühlung der Infrarotstrahler und des Reflektors. Darüber hinaus weisen die zur Herstellung von gedruckter Elektronik eingesetzten Substrate in der Regel nur eine begrenzte thermische Stabilität auf, so dass durch das Kühlelement eine übermäßige Erwärmung und Beschädigung des Substrats verhindert wird.

### Ausführungsbeispiel

Nachfolgend wird die Erfindung anhand von Ausführungsbeispielen und drei Figuren näher beschrieben. Es zeigt in schematischer Darstellung:
- **Figur 1**: eine erste Ausführungsform der erfindungsgemäßen Vorrichtung zum Trocknen und Sintern einer metallhaltigen Tinte in Querschnittsdarstellung,
- **Figur 2**: eine zweite Ausführungsform der erfindungsgemäßen Vorrichtung in räumlicher Darstellung,
- **Figur 3**: eine Raytracing-Simulation der Bestrahlungsintensität für die zweite Ausführungsform der erfindungsgemäßen Vorrichtung gemäß Figur 2.

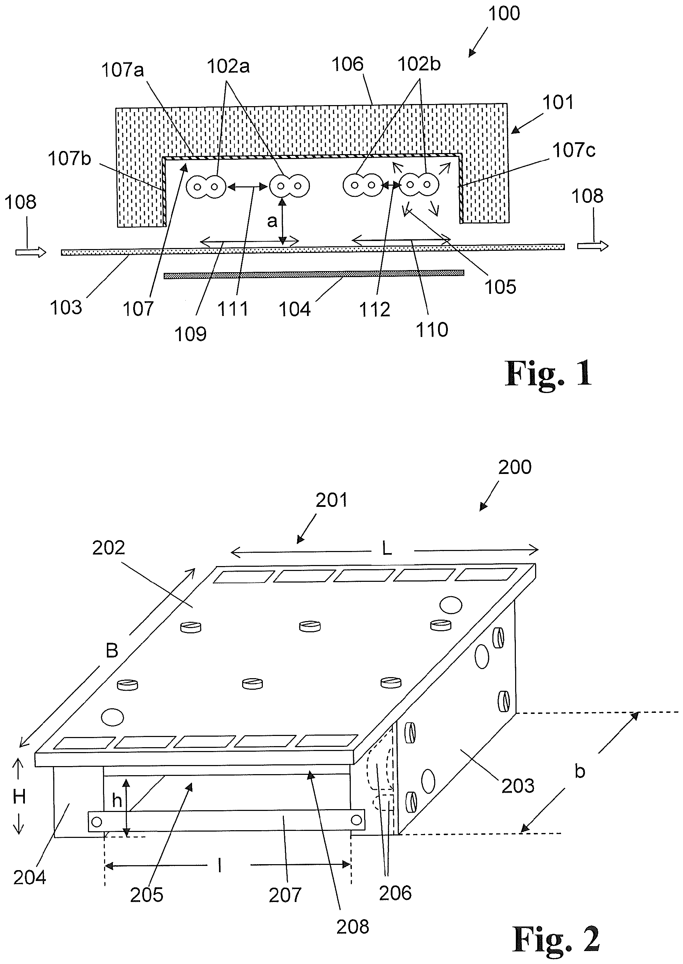

**Figur 1** zeigt schematisch eine erste Ausführungsform der erfindungsgemäßen Vorrichtung, der insgesamt die Bezugsziffer 100 zugeordnet. Die Vorrichtung 100 wird zum Trocknen und Sintern von metallhaltiger Tinte auf einem Substrat 103 eingesetzt. Sie eignet sich insbesondere zur Trocknung und Sinterung von Tinten in *Printed-Electronics-*Komponenten*,* die im Rolle-zu-Rolle-Verfahren hergestellt werden.

Die Vorrichtung 100 umfasst ein Strahlermodul 101 mit vier darin angeordneten Infrarotstrahlern 102a, 102b zur Emission von optischer Strahlung 105, einen Reflektor 107, sowie einen Spiegel 104 zur Reflexion eines Teils der vom Strahlermodul 101 emittierten Strahlung 105 auf das Substrat 103.

Die Infrarotstrahler 102a, 102b sind Zwillingsrohrstrahler, die für einen kontinuierlichen Betrieb ausgelegt sind; sie weisen ein zylinderförmiges Strahlerrohr mit einer Strahlerrohr-Längsachse auf. Die Infrarotstrahler 102a sind Carbonstrahler mit einer Farbtemperatur von 1.200 °C; sie sind der Trocknungszone zugeordnet und weisen ein Emissionsmaximum bei einer Wellenlänge von etwa 1,9 µm auf. Die Infrarotstrahler 102b sind kurzwellige Infrarotstrahler mit einer Farbtemperatur von etwa 2.200°C; sie tragen wesentlich zur Erzeugung der Sinterzone bei. Das Emissionsmaximum dieser Strahler liegt bei einer Wellenlänge von etwa 1,2 µm. Beide Infrarotstrahler-Typen 102a, 102b emittieren Strahlung mit einem Strahlungsanteil an IR-B-Strahlungvon mehr als 30% und im IR-C-Bereich von mehr als 5% der Gesamtstrahlerleistung. Darüber hinaus emittieren beide Infrarotstrahler-Typen 102a, 102b mehr als 10% der Gesamtstrahlerleitung im IR-A- Bereich und im sichtbaren Bereich.

Die Infrarotstrahler 102 sind innerhalb des Strahlermoduls 101 parallel zueinander und senkrecht zur Transportrichtung 108 angeordnet.

Benachbarte Infrarotstrahler 102a weisen einen Abstand 111 zueinander von 55 mm, benachbarte Infrarotstrahler 102b weisen einen Abstand zueinander von 38 mm auf. Der Abstand a zwischen der Strahlerunterseite der Infrarotstrahler 102a, 102b und dem Substrat beträgt 60 mm. Eine Verstelleinheit (nicht dargestellt) ermöglicht eine einfache Einstellung des Abstands a in einem Bereich von 35 mm bis 185 mm.

Das Strahlermodul 101 weist ein zweiseitig abgewinkeltes Gehäuse 106 mit einer den Infrarotstrahlern zugewandten Seite auf. Auf diese Seite ist der Reflektor 107 aufgebracht. Dadurch, dass der Reflektor 107 ein Basisreflektor 107a und zwei Seitenreflektoren 107b, 107c umfasst, wird ein großer Anteil der von den Infrarotstrahlern 102 emittierten Infrarotstrahlung auf dem Substrat 103 eingekoppelt. Der Reflektor 107 ist aus Aluminium gefertigt und zur Reflexion von Infrarotstrahlung mit einer Wellenlänge im Bereich von 800 nm bis 5.000 nm geeignet. In einer alternativen Ausführungsform (nicht dargestellt) ist auf das Gehäuse eine hochreflektierende Beschichtung aus Aluminium, Silber, Gold, Kupfer, Nickel oder Chrom aufgebracht.

Das Strahlermodul 101 bestrahlt ein Bestrahlungsfeld auf der Oberfläche des Substrats 103, das in Transportrichtung 108 gesehen eine Trocknungszone 109 sowie eine der Trocknungszone 109 nachgelagerte Sinterzone 110 aufweist. Das Strahlermodul 101 ist für eine Bestrahlung des Bestrahlungsfeldes mit einer mittleren Bestrahlungsdichte von etwa 150 kW/m² ausgelegt. Das Bestrahlungsfeld weist einen Gesamtflächeninhalt von 1.800 cm² auf; der Flächeninhalt der Trocknungs- und Sinterzone beträgt jeweils etwa 750 cm². Trocknungs- und Sinterzone 109, 110 unterscheiden sich in ihrer mittleren Bestrahlungsdichte. Entlang einer in Transportrichtung verlaufenden Mittenachse beträgt die mittlere Bestrahlungsdichte in der Trocknungszone 109 50 kW/m² und in der Sinterzone 110 250 kW/m².

Das Substrat 103 ist eine Kunststofffolie aus PET mit einer Folienstärke von 0,1 mm, die von einer Transportvorrichtung (nicht dargestellt) in Transportrichtung 108 relativ zum Strahlermodul 101 bewegt wird. Die Bewegung des Substrats 103 erfolgt mit einer konstanten Vorschubgeschwindigkeit.

Innerhalb des Gehäuses 106 ist ein Kühlelement (nicht dargestellt) zur Kühlung des Reflektors 107 und der Infrarotstrahler 102 vorgesehen. Das Kühlelement ist eine Wasserkühlung. Sie trägt zu einer hohen Lebensdauer der Vorrichtung, insbesondere der Strahler und der Reflektorschicht, bei. In einer alternativen Ausführungsform ist das Kühlelement eine Luftkühlung. Dabei ist das Kühlelement so ausgelegt, dass das Substrat 103 aufgrund seiner geringen thermischen Masse nicht durch einen vom Strahlermodul 101 ausgehenden Luftstrom abgekühlt wird. Dies wird beispielsweise durch eine Luft-Rückkühlung des Reflektors 107 oder eine Luftkühlung der Infrarotstrahler 102 und des Reflektors 107 mit besonderer Luftführung und seitlichem Luftauslass erreicht.

**Figur 2** zeigt schematisch in räumlicher Darstellung ein Strahlermodul 200 zum Einsatz in eine erfindungsgemäße Vorrichtung zum Trocknen und Sintern metallhaltiger Tinte.

Das Strahlermodul 200 umfasst 12 Infrarotstrahler (nicht dargestellt), sowie ein aus mehreren Platten 202, 203, 204 gefertigtes Gehäuse 201. Die Außenabmessungen des Strahlermoduls 200 betragen 650 mm x 450 mm x 160 mm (L x B x H). Weiterhin ist ein Innen-Reflektor 205 vorgesehen, der auf die innere Oberfläche des Strahlmodul-Gehäuses 201 aufgebracht ist. Der Innenreflektor 205 bedeckt die Innenflächen der Platten 203, 204, 208. An den Stirnseiten sind darüber hinaus Reflektorbleche 207 angebracht. Durch den Reflektor 205, insbesondere die seitlichen Reflektoren auf den Platten 203, 204, und die Reflektorbleche 207 steht ein möglichst großer Teil der von den Infrarotstrahlern emittierten Strahlung für die Bestrahlung des Substrats zur Verfügung. Der Innenreflektor 205 ist den beheizten Bereichen der Infrarotstrahler zugeordnet. Die unbeheizten Enden der Strahler ragen aus dem Bereich des Reflektors 205 heraus. Das Strahlermodul 200 ist zur Bestrahlung eines Bestrahlungsfelds mit den Dimensionen 600 mm x 350 mm (l x b) ausgelegt. Die Unterseite der Infrarotstrahler-Unterseite weist zum Substrat einen Abstand h von 50 mm auf.

Die Infrarotstrahler sind so gewählt und innerhalb des Strahlermoduls 200 angeordnet, dass das vom Strahlermodul 200 erzeugte Bestrahlungsprofil auf dem Bestrahlungsfeld eine Trocknungszone und eine Sinterzone umfasst. Die Infrarotstrahler sind an den unbeheizten Enden an der Platte 202 derart befestigt, dass ihre Position in Längsrichtung l verstellt werden kann und sich somit verschiedene Bestrahlungsprofile des Bestrahlungsfelds einstellen lassen.

Innerhalb der Platten 202, 203, 204 ist des Gehäuses 201 ist jeweils ein Kühlelement in Form einer Wasserkühlung 206 zur Kühlung des Innenreflektors 205 und der Infrarotstrahler angeordnet.

Die Platten 202, 203, 204 mit Kühlelement können durch verschiedene Verfahren hergestellt sein, beispielsweise durch Aufschweißen oder Löten eines mäanderförmigen U-Profils auf eine ebene Grundplatte, durch Aufschweißen oder Löten von Halbrohren auf eine ebene Grundplatte oder durch Fräsen von Kanälen in eine Grundplatte und anschließendes Verpressen von Kupferrohren in die Kanäle.

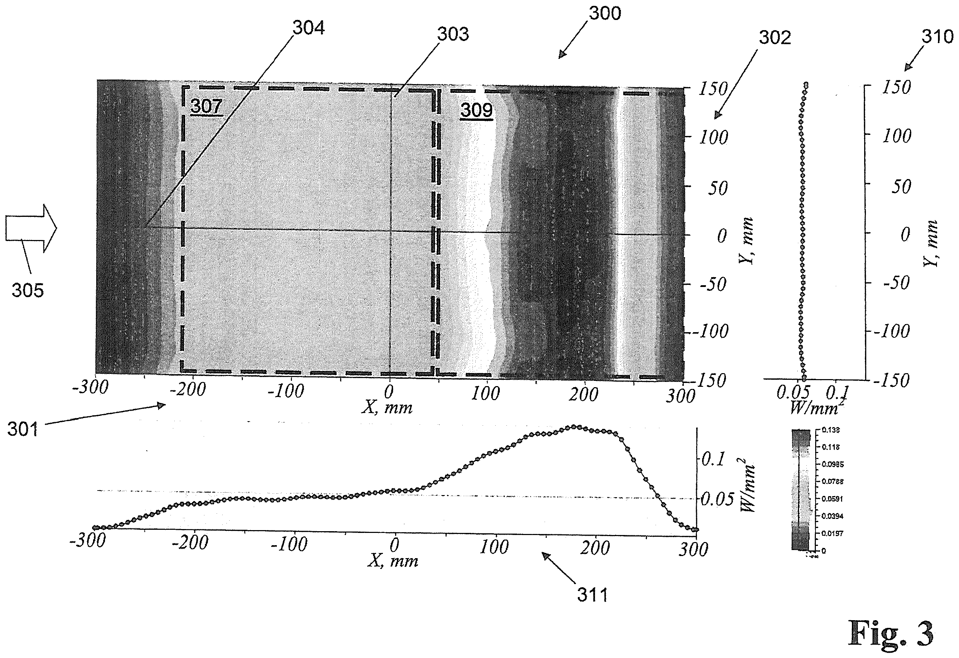

**Figur 3** zeigt eine Raytracing-Simulation der Bestrahlungsintensität der zweiten Ausführungsform der erfindungsgemäßen Vorrichtung. Im Diagramm 300 ist die Infrarot-Bestrahlungsdichte in W/mm² in einem Bestrahlungsfeld mit einer Größe von 300 mm x 600 mm auf der Oberfläche eines Substrats aus PET-Folie dargestellt. Die Transportrichtung der PET-Folie relativ zum Strahlermodul der Vorrichtung ist in Figur 3 durch den Pfeil 305 angegeben.

Der Raytracing-Simulation liegt das Strahlermodul 200 zugrunde; es ist durch eine Bestrahlungsbreite b von 350 mm, eine Bestrahlungslänge l von 600 mm und einen Höhe h von 50,5 mm gekennzeichnet.

Das Strahlermodul 200 ist mit acht IR-Zwillingsrohrstrahlern bestückt, von denen vier eine Leistung von 2 x 2.725 Watt (Sinterzone) und vier eine Leistung von 2 x 1200 Watt (Trocknungszone) aufweisen, wobei jeweils nur ein Kanal aktiv ist. Benachbarte Zwillingsrohrstrahler in der Trocknungszone weisen einen Abstand von 70 mm und in der Sinterzone von 45 mm auf.

Der Abstand der Strahlerunterseiten zur PET-Oberfläche beträgt 50 mm. Auf der der PET-Folie zugewandten Seite des Strahlermoduls ist ein Reflektor in Form einer Goldbeschichtung aufgebracht.

Auf der Abszisse 301 des Diagramms 300 ist die Größe des Bestrahlungsfelds in x-Richtung in mm aufgetragen; die Ordinate 302 gibt die Erstreckung des Bestrahlungsfelds in y-Richtung wieder. Das Diagramm 300 zeigt die Verteilung der Bestrahlungsintensität im Bestrahlungsfeld in Graustufendarstellung.

Das Bestrahlungsfeld wird durch eine in Transportrichtung 305 verlaufende Mittenachse 304 und eine senkrecht zur Mittenachse 304 verlaufende Senkrechte 303 in vier gleichgroße Teilflächen unterteilt.

Die Raytracing-Simulation zeigt ein Bestrahlungsfeld, das zwei Bestrahlungszonen umfasst, nämlich eine Trocknungszone 307 und eine Sinterzone 309. Die Trocknungszone 307 weist entlang der Mittenachse 304 eine mittlere Bestrahlungsdichte von etwa 50 kW/m² auf. Die Bestrahlungsdichte entlang der Mittenachse 304 beträgt in der Sinterzone 135 kW/m².

Das Diagramm 310 zeigt darüber hinaus den Verlauf der Bestrahlungsintensität in W/mm² in Richtung der Senkrechten 303. Das Diagramm 311 gibt den Verlauf der Bestrahlungsintensität entlang der Mittenachse 304 wieder.

### Beispiel

Eine Plastikfolie aus Polyethylennaphthalat (PEN) mit einer Foliendicke von 100 µm wird mit einem Tintenstrahldrucker (Dimatix DMP283; Dropspace 25/30µm) mit metallhaltiger Tinte bedruckt. Als Tinte wird eine Dispersion von Silber-Nanopartikeln (20 Gew.-%) in organischen Lösungsmitteln verwendet (Suntronic® Jet Silver U5603).

Die bedruckte Plastikfolie wird anschließend mit einer Vorrichtung getrocknet, die ein Strahlermodul mit 2 x 2 kurzwelligen Infrarotstrahlern mit einem zylinderförmigen Strahlerrohr umfasst. Die beheizte Länge der Strahlerrohre beträgt 150 mm. Auf der der Beschichtung abgewandten Seite der Strahlerrohre ist ein Goldreflektor aufgebracht. Die Infrarotstrahler weisen ein breites Wellenlängenspektrum und eine Farbtemperatur kleiner als 2.500 °C auf. Sie sind für eine elektrische Leistung von 4 x 0,7 kW ausgelegt. Die Flächenleistung des Strahlermoduls beträgt 50 kW/m². Der Abstand der Strahler zur Folie beträgt ca. 50 mm. Auf der Unterseite der Folie ist ein Ceraboard Strahlungswandler angeordnet. Der Abstand des Strahlungswandlers zur Unterseite der Folie beträgt etwa 120 mm.

Zum Trocknen und Sintern der Tintenschicht wird die Folie in Transportrichtung mit einer Bandgeschwindigkeit von 4 cm/s relativ zum Strahlermodul bewegt. Die Prozesszeit beträgt 10 s (zum Vergleich: Prozesszeit mit Warmluft (140°C): 40 s).

Die gesinterte Beschichtung weist eine gute elektrische Leitfähigkeit auf; ihr Widerstand beträgt 3 Ohm.

## Patentansprüche

1. Vorrichtung zum Trocknen und Sintern metallhaltiger Tinte auf einem Substrat, aufweisend mehrere optische Strahler zur Bestrahlung des Substrats und einen Reflektor zur Reflexion von Strahlung auf das Substrat, wobei Strahler und Substrat in einer Transportrichtung relativ zueinander bewegbar sind, wobei die optischen Strahler Infrarotstrahler mit einem zylinderförmigen Strahlerrohr und einer Strahlerrohr-Längsachse sind, die Strahlung mit einem Strahlungsanteil an IR-B-Strahlung von mindestens 30% und an IR-C-Strahlung von mindestens 5% der Gesamtstrahlerleistung emittieren und die in einem Strahlermodul so angeordnet sind, dass ihre Strahlerrohr-Längsachsen parallel zueinander und quer zur Transportrichtung verlaufen, wobei die Infrarotstrahler dabei auf der Oberfläche des Substrats ein Bestrahlungsfeld derart bestrahlen, dass dieses in eine Trocknungszone sowie eine der Trocknungszone in Transportrichtung gesehen nachgelagerte Sinterzone geteilt wird, wobei die Trocknungszone entlang einer in Transportrichtung verlaufenden Mittenachse eine um mindestens 15% geringere mittlere Bestrahlungsdichte als die Sinterzone ausgesetzt ist, und dass die Infrarotstrahler einen Infrarotstrahler einer ersten Art mit einem Emissionsmaximum im Wellenlängenbereich zwischen 1.600 nm und 3.000 nm zur Bestrahlung der Trocknungszone und einen Infrarotstrahler einer zweiten Art mit einem Emissionsmaximum im Wellenlängenbereich zwischen 900 nm und 1.600 nm zur Bestrahlung der Sinterzone umfassen.

2. Vorrichtung nach Anspruch 1, **dadurch gekennzeichnet, dass** mehrere Infrarotstrahler der ersten Art und mehrere Infrarotstrahler der zweiten Art vorgesehen sind, und dass benachbarte Infrarotstrahler der ersten Art einen größeren Abstand zueinander aufweisen als benachbarte Infrarotstrahler der zweiten Art.

3. Vorrichtung nach einem der vorhergehenden Ansprüche, **dadurch gekennzeichnet, dass** die Infrarotstrahler die Strahlung kontinuierlich emittieren.

4. Vorrichtung nach einem der vorhergehenden Ansprüche, **dadurch gekennzeichnet, dass** die Infrarotstrahler ein breitbandiges Emissionsspektrum aufweisen, das Strahlungsanteile von zusammen mindestens 10% der Gesamtstrahlerleistung im sichtbaren Bereich und im IR-A-Bereich aufweist.

5. Vorrichtung nach einem der vorhergehenden Ansprüche, **dadurch gekennzeichnet, dass** das Bestrahlungsfeld einen Gesamtflächeninhalt im Bereich von 800 cm² bis 6.000 cm² aufweist, und dass der Flächeninhalt der Trocknungszone und der Sinterzone jeweils mindestens 30% des Gesamtflächeninhalts ausmacht, vorzugsweise der Flächeninhalt der Trocknungszone im Bereich zwischen 35% und 65% des Gesamtflächeninhalts liegt.

6. Vorrichtung nach einem der vorhergehenden Ansprüche, **dadurch gekennzeichnet, dass** die Trocknungszone und die Sinterzone den gleichen Flächeninhalt aufweisen.

7. Vorrichtung nach einem der vorhergehenden Ansprüche, **dadurch gekennzeichnet, dass** die Trocknungszone entlang der Mittenachse eine mittlere Bestrahlungsdichte von weniger als 50 kW/m² aufweist.

8. Vorrichtung nach einem der vorhergehenden Ansprüche, **dadurch gekennzeichnet, dass** die Sinterzone entlang der Mittenachse eine Bestrahlungsdichte von mehr als 50 kW/m² aufweist.

9. Vorrichtung nach einem der vorhergehenden Ansprüche, **dadurch gekennzeichnet, dass** das Strahlermodul für eine Bestrahlung des Bestrahlungsfelds mit einer mittleren Bestrahlungsdichte im Bereich von 30 kW/m² bis 250 kW/m² ausgelegt ist.

10. Vorrichtung nach einem der vorhergehenden Ansprüche, **dadurch gekennzeichnet, dass** das Strahlermodul ein Kühlelement, vorzugsweise eine Wasserkühlung, aufweist, das einer den Infrarotstrahlern abgewandten Seite des Reflektors angeordnet ist

## Claims

1. Device for drying and sintering metal-containing ink on a substrate, comprising multiple optical radiators for irradiation of the substrate and a reflector for reflection of radiation onto the substrate, wherein radiator and substrate can be moved with respect to each other in a transport direction, wherein the optical radiators are infrared radiators with a cylinder-shaped radiator tube and a radiator tube longitudinal axis that emit radiation with a radiation fraction of IR-B radiation of at least 30% and of IR-C radiation of at least 5% of the total radiator power and are appropriately arranged in a radiator module such that their radiator tube longitudinal axes extend parallelly with respect to each other and transversely with respect to the transport direction,
wherein the infrared radiators in this context irradiate an irradiation field on the surface of the substrate such that the same is divided into a drying zone and a sintering zone that is situated downstream from the drying zone as seen in the transport direction, wherein the drying zone is exposed to an at least 15% lower mean irradiation density than the sintering zone along a middle axis that extends in the transport direction, and wherein the infrared radiators comprise an infrared radiator of a first type having an emission maximum in the wavelength range between 1600 nm and 3000 nm for irradiation of the drying zone and an infrared radiator of a second type with an emission maximum in the wavelength range between 900 nm and 1600 nm for irradiation of the sintering zone.

2. Device according to claim 1, **characterised in that** multiple infrared radiators of the first type and multiple infrared radiators of the second type are provided and **in that** adjacent infrared radiators of the first type are situated at a larger distance from each other than adjacent infrared radiators of the second type.

3. Device according to any one of the preceding claims, **characterised in that** the infrared radiators emit the radiation continuously.

4. Device according to any one of the preceding claims, **characterised in that** the infrared radiators comprise a broadband emission spectrum that comprises radiation fractions of, taken together, at least 10% of the total radiator power in the visible range and in the IR-A range.

5. Device according to any one of the preceding claims, **characterised in that** the irradiation field comprises a total surface area in the range of 800 cm² to 6000 cm², and **in that** the surface area of the drying zone and of the sintering zone each accounts for at least 30% of the total surface area, with the surface area of the drying zone preferably being in the range of 35% to 65% of the total surface area.

6. Device according to any one of the preceding claims, **characterised in that** the drying zone and the sintering zone comprise the same surface area.

7. Device according to any one of the preceding claims, **characterised in that** the drying zone comprises a mean irradiation density of less than 50 kW/m² along the middle axis.

8. Device according to any one of the preceding claims, **characterised in that** the sintering zone comprises an irradiation density of more than 50 kW/m² along the middle axis.

9. Device according to any one of the preceding claims, **characterised in that** the radiator module is designed for irradiation of the irradiation field at a mean irradiation density in the range of 30 kW/m² to 250 kW/m².

10. Device according to any one of the preceding claims, **characterised in that** the radiator module comprises a cooling element, preferably a water cooling, that is arranged on a side of the reflector facing away from the infrared radiators.

## Revendications

1. Dispositif de séchage et frittage d'encres contenant du métal sur un substrat, présentant plusieurs lampes optiques pour l'irradiation du substrat et un réflecteur pour la réflexion du rayonnement sur le substrat, dans lequel lampes et substrat peuvent être déplacés les uns par rapport aux autres dans un sens de transport, dans lequel les lampes optiques sont des lampes infrarouge avec un tube de lampe cylindrique et un axe longitudinal de tube de lampe qui émettent un rayonnement avec une proportion de rayonnement en rayonnement IR-B d'au moins 30 % et en rayonnement IR-C d'au moins 5 % de la puissance de lampe totale et qui sont disposées dans un module de lampes de sorte que leurs axes longitudinaux de tube de lampe s'étendent parallèlement les uns aux autres et transversalement au sens de transport, dans lequel les lampes infrarouge irradient ce faisant sur la surface du substrat un champ d'irradiation de telle sorte que celui-ci est divisé en une zone de séchage ainsi qu'une zone de frittage logée en aval de la zone de séchage vue dans le sens de transport, dans lequel la zone de séchage est exposée le long d'un axe médian s'étendant dans le sens de transport à une densité d'irradiation moyenne inférieure d'au moins 15 % à la zone de frittage, et que les lampes infrarouge comprennent une lampe infrarouge d'un premier type avec un maximum d'émission dans la région de longueurs d'onde entre 1600 nm et 3000 nm pour l'irradiation de la zone de séchage et une lampe infrarouge d'un second type avec un maximum d'émission dans la région de longueurs d'onde entre 900 nm et 1600 nm pour l'irradiation de la zone de frittage.

2. Dispositif selon la revendication 1, **caractérisé en ce que** plusieurs lampes infrarouge du premier type et plusieurs lampes infrarouge du second type sont prévues, et que des lampes infrarouge voisines du premier type présentent un écart supérieur les unes par rapport aux autres à des lampes infrarouge voisines du second type.

3. Dispositif selon une des revendications précédentes, **caractérisé en ce que** les lampes infrarouge émettent le rayonnement en continu.

4. Dispositif selon une des revendications précédentes, **caractérisé en ce que** les lampes infrarouge présentent un spectre d'émission à large bande qui présente des proportions de rayonnement ensemble d'au moins 10 % de la puissance de lampe totale dans le domaine visible et dans le domaine IR-A.

5. Dispositif selon une des revendications précédentes, **caractérisé en ce que** le champ d'irradiation présente une superficie totale dans la région de 800 cm² à 6000 cm², et que la superficie de la zone de séchage et de la zone de frittage représente à chaque fois au moins 30 % de la superficie totale, de préférence la superficie de la zone de séchage se situe dans la région comprise entre 35 % et 65 % de la superficie totale.

6. Dispositif selon une des revendications précédentes, **caractérisé en ce que** la zone de séchage et la zone de frittage présentent la même superficie.

7. Dispositif selon une des revendications précédentes, **caractérisé en ce que** la zone de séchage présente le long de l'axe médian une densité d'irradiation moyenne de moins de 50 kW/m².

8. Dispositif selon une des revendications précédentes, **caractérisé en ce que** la zone de frittage présente le long de l'axe médian une densité d'irradiation de plus de 50 kW/m².

9. Dispositif selon une des revendications précédentes, **caractérisé en ce que** le module de lampes est conçu pour une irradiation du champ d'irradiation avec une densité d'irradiation moyenne dans la région de 30 kW/m² à 250 kW/m².

10. Dispositif selon une des revendications précédentes, **caractérisé en ce que** le module de lampes présente un élément de refroidissement, de préférence un refroidissement aqueux, qui est disposé sur un côté du réflecteur détourné des lampes infrarouge.
